# EUROPEAN PATENT APPLICATION

(11) **EP 4 629 507 A1**
(43) Date of publication of application: **08.10.2025**
(21) Application number: 23896424.1
(22) Date of filing: 31.10.2023
(51) Int. Cl.: H03H 9/10

(54) **FILTER STRUCTURE INTEGRATED WITH IPD CHIP, PACKAGING MODULE, AND MANUFACTURING METHOD**

(30) Priority: 01.12.2022 CN 202211611324; 16.12.2022 CN 202211622379
(71) Applicant: Vanchip (Tianjin) Technology Co. Ltd, Tianjin 300457 (CN)
(72) Inventor: JIANG, Pinfang, Tianjin 300457 (CN); ZHU, Yong, Tianjin 300457 (CN); ZHANG, Silong, Tianjin 300457 (CN); ZHANG, Lei, Tianjin 300457 (CN); LIN, Hongkuan, Tianjin 300457 (CN)
(74) Representative: Wang, Bo
(86) International application number: PCT/CN2023/128781
(87) International publication number: WO 2024/114270

(57) **Abstract**

Disclosed in the present invention are a filter structure integrated with an IPD chip, a packaging module, and a manufacturing method. The filter structure comprises: an IPD chip, used for being electrically connected to a module substrate; a filter chip, disposed on the surface of the IPD chip and electrically connected to the IPD chip; a thin film layer, covering the outer sides of the IPD chip and the filter chip; and a plastic packaging layer, used for plastic packaging of the surface of the IPD chip so as to completely cover the thin film layer. According to the filter structure, an IPD chip needing to be mounted on a module substrate is integrated on a filter, so that the space utilization rate of the applied module substrate on which the filter is subsequently mounted is increased. The IPD chip is integrated as a filter packaging substrate without increasing the size of the filter so as to achieve filter packaging, and the filter is enabled to form a complete circuit, thereby ensuring the use effect of the filter.

## Description

### BACKGROUND

### Technical Field

The present disclosure relates to a filter structure integrated with an IPD chip, and also relates to a packaging module containing the filter structure and a manufacturing method of the filter structure, belonging to the technical field of semiconductor packages.

### Related Art

Currently, an acoustic filter is usually packaged in chip scale package (Chip Scale Package, CSP), die-sized SAW packaging (DSSP) and wafer level package (WLP). During integration into a packaging module, circuit matching is needed on a substrate. In addition, other dies in the packaging module also need capacitors, resistors and inductors to adjust the circuit, which makes integrated passive device (Integrated Passive Device, IPD) dies gradually widely applied.

However, the IPD die is essentially a discrete device, which is mainly used as an extension filter or other dies that need circuit matching to form a complete circuit and occupies some space when being attached and connected to a module substrate. With the demand for miniaturization of semiconductor structures, the space on the substrate is increasingly limited, so achieving the same functions while reducing space of the substrate is a technical problem that researchers need to solve urgently.

### SUMMARY

The primary technical problem to be solved by the present disclosure is to provide a filter structure integrated with an IPD chip.

Another technical problem to be solved by the present disclosure is to provide a packaging module of a filter structure.

Still another technical problem to be solved by the present disclosure is to provide a manufacturing method of a filter structure integrated with an IPD chip.

In order to achieve the above technical objectives, the present disclosure adopts the following technical solutions:
A first aspect of embodiments of the present disclosure provides a filter structure integrated with an IPD chip, including:
an IPD die, configured to be electrically connected to a module substrate;
a filter die, arranged on a surface of the IPD die and electrically connected to the IPD die;
a thin film layer, covering outer sides of the IPD die and the filter die; and
an encapsulation layer, encapsulating the surface of the IPD die to completely cover the thin film layer.

Preferably, the filter die includes:
a filter die body, located above the surface of the IPD die;
conductive pads, formed on a bonding surface of the filter die body and electrically connected to the IPD die such that an accommodating cavity is formed between the bonding surface of the filter die body and the surface of the IPD die, where the bonding surface of the filter die body is close to the surface of the IPD die; and
an interdigital transducer, formed on the bonding surface of the filter die body and located in the accommodating cavity.

Preferably, the thin film layer is replaced with retaining walls, and the retaining walls are arranged between the IPD die and the filter die body to prevent an encapsulant from entering the accommodating cavity.

Preferably, the retaining walls are arranged on outer sides of the conductive pads; or
the retaining walls are arranged on inner sides of the conductive pads and located on an outer side of the interdigital transducer.

Preferably, an encapsulant of the encapsulation layer at least satisfies the following: a particle diameter of the encapsulant is greater than a preset diameter; and/or a flow velocity of the encapsulant is less than a preset flow velocity; and/or a viscosity of the encapsulant is greater than a preset viscosity.

Preferably, the filter structure further includes a carrier. A surface of the carrier is provided with multiple the IPD dies, and a preset spacing is provided between every two adjacent IPD dies such that a dicing blade performs dicing.

A second aspect of embodiments of the present disclosure provides a packaging module of a filter structure, including:
a module substrate, provided with a preset circuit therein; and
the filter structure described above, an IPD die of the filter structure being attached to a surface of the module substrate and electrically connected to the preset circuit.

A third aspect of embodiments of the present disclosure provides a manufacturing method of a filter structure integrated with an IPD chip, including the following steps:
arranging an adhesive on a surface of a carrier;
attaching multiple IPD dies to preset positions on the surface of the carrier respectively;
attaching multiple filter dies to surfaces of the multiple IPD dies respectively such that conductive pads of the multiple filter dies are electrically connected to the multiple IPD dies respectively;
using a polymer thin film to cover the IPD dies and the filter dies so as to form a thin film layer;
using an encapsulant to encapsulate the surface of the carrier and completely cover the thin film layer so as to form an encapsulation layer; and
performing dicing after the encapsulation is completed, and removing the carrier to form the individual filter structure integrated with an IPD chips.

Preferably, the using a polymer thin film to cover the IPD dies and the filter dies so as to form the thin film layer is replaced with:
arranging retaining walls between the IPD die and the filter die in each group such that the retaining walls are located on outer sides of the conductive pads of the filter die.

Preferably, the using a polymer thin film to cover the IPD dies and the filter dies so as to form the thin film layer is replaced with:
arranging retaining walls between the IPD die and the filter die in each group such that the retaining walls are located on inner sides of the conductive pads of the filter die and on an outer side of an interdigital transducer of the filter die.

Compared with the prior art, according to the filter structure integrated with an IPD chip and the manufacturing method thereof provided by the embodiments of the present disclosure, the IPD die that needs to be attached to the module substrate is integrated onto a filter, thereby increasing a space utilization rate of the applied module substrate when the filter is attached subsequently. Moreover, without increasing a size of the filter, the IPD die is integrated as a filter package substrate to realize a filter package and allow the filter to form a complete circuit, thereby ensuring a use effect of the filter.

### BRIEF DESCRIPTION OF THE DRAWINGS

FIG. 1 is a schematic structural diagram of a filter structure integrated with an IPD chip according to a first embodiment of the present disclosure;
FIG. 2 is a schematic structural diagram of another filter structure integrated with an IPD chip according to a second embodiment of the present disclosure;
FIG. 3 is a schematic structural diagram of another filter structure integrated with an IPD chip according to the second embodiment of the present disclosure;
FIG. 4 is a schematic structural diagram of another filter structure integrated with an IPD chip according to the second embodiment of the present disclosure;
FIG. 5 is a schematic structural diagram of still another filter structure integrated with an IPD chip according to a third embodiment of the present disclosure;
FIG. 6 is a schematic structural diagram of a packaging module of a filter structure according to a fourth embodiment of the present disclosure;
FIG. 7 is a schematic structural diagram of a carrier in a fifth embodiment of the present disclosure;
FIG. 8 is a schematic structural diagram of attaching IPD dies to the carrier in the fifth embodiment of the present disclosure;
FIG. 9 is a schematic structural diagram of attaching filter dies to the IPD dies in the fifth embodiment of the present disclosure;
FIG. 10 is a schematic structural diagram of covering with a polymer thin film in the fifth embodiment of the present disclosure; and
FIG. 11 is a schematic structural diagram of encapsulation in the fifth embodiment of the present disclosure.

### DETAILED DESCRIPTION

The technical contents of the present disclosure will be described in detail below with reference to the accompanying drawings and specific embodiments.

### First Embodiment

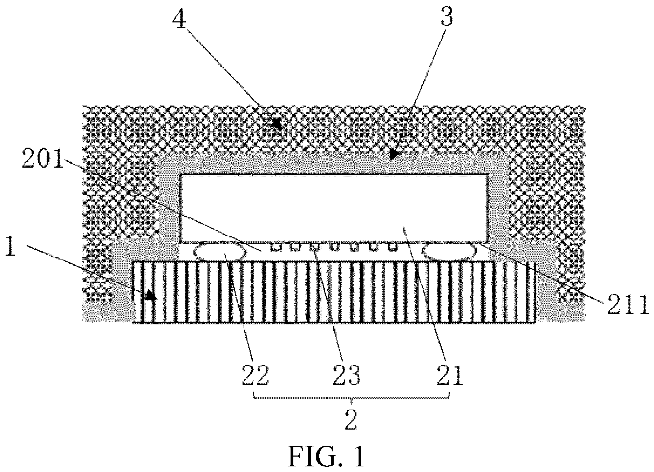

As shown in FIG. 1, a first embodiment of the present disclosure provides a filter structure integrated with an IPD chip, including an IPD die 1, a filter die 2, a thin film layer 3 and an encapsulation layer 4.

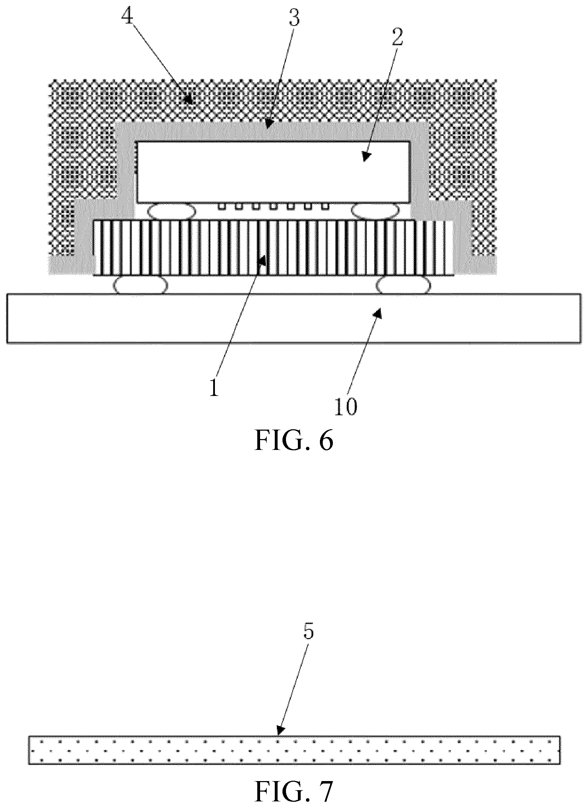

The IPD die 1 is configured to be electrically connected to a module substrate 10 (as shown in FIG. 6). The filter die 2 is arranged on an upper surface of the IPD die 1 and electrically connected to the IPD die 1. The thin film layer 3 covers outer sides of the IPD die 1 and the filter die 2. The encapsulation layer 4 encapsulates the surface of the IPD die 1 to completely cover the thin film layer 3.

In this embodiment, the IPD die 1 is equivalent to a substrate of a filter, and the filter die 2, the thin film layer 3 and the encapsulation layer 4 are sequentially attached and encapsulated to form the complete filter structure. The IPD die 1 may be subjected to a TSV process to form electrical circuits on surfaces (a top surface and a bottom surface in this embodiment) of the die, so that after the subsequent integration of the filter structure, the bottom surface of the IPD die 1 can be electrically connected to the module substrate 10 and the top surface of the IPD die 1 can be electrically connected to the filter die 2. Thereby, in specific use, the IPD die 1 that needs to be attached to the module substrate 10 is integrated onto a filter, thereby increasing a space utilization rate of the applied module substrate when the filter is attached subsequently. In this embodiment, without increasing a size of the filter, the IPD die 1 is integrated as a filter package substrate to realize a filter package and allow the filter to form a complete circuit, thereby ensuring a use effect of the filter.

In the above embodiment, the filter die 2 includes a filter die body 21, conductive pads 22 and an interdigital transducer 23. The filter die body 21 is located above the IPD die 1, and has a bonding surface 211 close to an upper surface of the IPD die 1. The conductive pads 22 are formed on the bonding surface 211 of the filter die body and electrically connected to the IPD die 1. Moreover, since the conductive pads 22 have a certain thickness, after the conductive pads 22 are electrically connected to the upper surface of the IPD die 1, the bonding surface 211 of the filter die body, the upper surface of the IPD die and the conductive pads 22 jointly form a rectangular accommodating cavity 201. The interdigital transducer 23 (i.e., IDT) is formed on the bonding surface 211 of the filter die body and located in the accommodating cavity 201.

In the above embodiment, a height (a distance in an up-down direction in FIG. 1) of the interdigital transducer 23 is less than a thickness of the conductive pads 22, and the interdigital transducer 23 is located between the two conductive pads 22 in a left-right direction in FIG. 1. Thereby, after the conductive pads 22 are electrically connected to the upper surface of the IPD die 1, the interdigital transducer 23 can be located exactly in the accommodating cavity 201, and there is a safety gap between the interdigital transducer 23 and the upper surface of the IPD die 1, which can prevent the interdigital transducer 23 from being squeezed and deformed. In addition, it can be understood that in FIG. 1, the conductive pads 22 are not only present on the left and right sides of the interdigital transducer 23, and may also be present on the front and rear sides of the interdigital transducer 23. Moreover, when viewed from the front-rear direction, the interdigital transducer 23 is still located between the two front and rear conductive pads 22, so that the whole interdigital transducer 23 is enclosed.

In the above embodiment, the thin film layer 3 is a polymer thin film. Covering The polymer thin film over the dies (i.e., IPD dies+filter dies) forms a protective layer, which can prevent the encapsulant from entering the filter dies 2 during the subsequent encapsulation process and further from affecting the performance of the filter dies 2, thereby improving the overall safety. In this embodiment, the specific material of the thin film layer 3 is not limited and may be adaptively selected according to actual needs.

In the above embodiment, the encapsulation layer 4 is preferably an epoxy encapsulant, and the encapsulant has fluidity. Under the condition of a constant encapsulation pressure, the viscosity of the encapsulant changes with time during the encapsulation process, so the main material parameter is that the filler size is generally greater than 5 um. The filler content is greater than 80 wt%. The content rate affects the viscosity and fluidity of the material. In addition, the greater the size, the more difficult for the encapsulant to break through the thin film and enter the cavity at the bottom of the filter die. In this embodiment, the encapsulant of the encapsulation layer 4 should satisfy at least one of the following conditions: first, a particle diameter of the encapsulant is greater than a preset diameter; second, a flow velocity of the encapsulant is less than a preset flow velocity; and third, the viscosity of the encapsulant is greater than a preset viscosity. It can be understood that the greater the particle diameter of the encapsulant, the more difficult for the encapsulant to flow into the accommodating cavity 201 through the gap between the filter die body 21 and the IPD die 1, and the smaller the particle diameter of the encapsulant, the easier for the encapsulant to flow into the accommodating cavity 201. Similarly, the smaller the flow velocity of the encapsulant, the more difficult for the encapsulant to flow into the accommodating cavity 201 through the gap between the filter die body 21 and the IPD die 1, and the greater the flow velocity of the encapsulant, the easier for the encapsulant to flow into the accommodating cavity 201. The greater the viscosity of the encapsulant, the more difficult for the encapsulant to flow into the accommodating cavity 201 through the gap between the filter die body 21 and the IPD die 1, and the smaller the viscosity of the encapsulant, the easier for the encapsulant to flow into the accommodating cavity 201. Therefore, when selecting the encapsulant, the encapsulant having a larger particle diameter, a smaller flow velocity and a larger viscosity should be selected as much as possible, so that the possibility of the encapsulant entering the accommodating cavity 201 can be reduced during the encapsulation process, thereby avoiding contaminating the filter. It can be understood that the three conditions listed in this embodiment are merely preferred selection conditions, and in other embodiments, other selection conditions may be added. Moreover, the more conditions satisfied by the encapsulant, the better the encapsulation effect. The encapsulant may be adaptively selected according to actual encapsulation needs.

### Second Embodiment

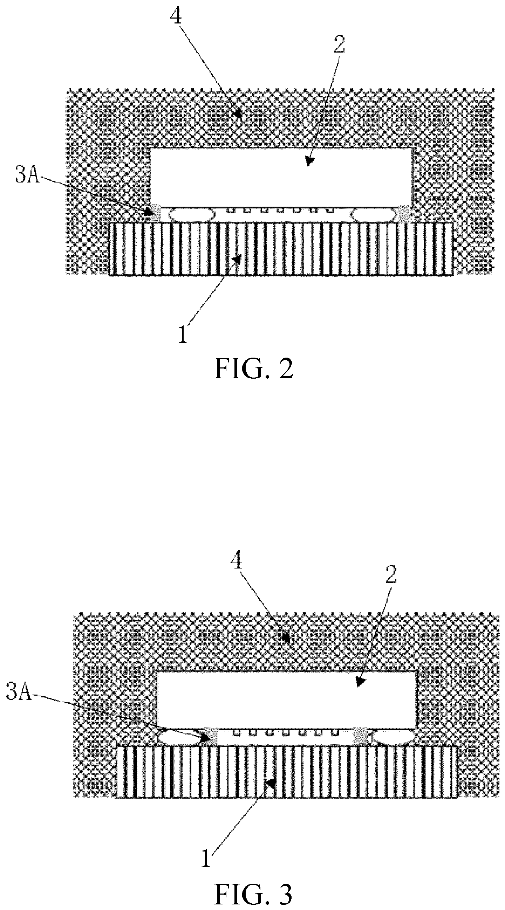

As shown in FIG. 2 to FIG. 4, based on the first embodiment, a second embodiment of the present disclosure provides another filter structure. This embodiment is different from the first embodiment in that the thin film layer 3 is replaced with retaining walls 3A.

Specifically, the retaining walls 3A are arranged between the IPD die 1 and the filter die body 21 to prevent the encapsulant from entering the accommodating cavity 201. A material of the retaining walls 3A is not limited here. The material may be a rigid material (e.g., convex columns) or a flexible material (e.g., a polymer thin film enclosing the bonding surface of the filter die body 21), and may be adaptively selected according to actual needs.

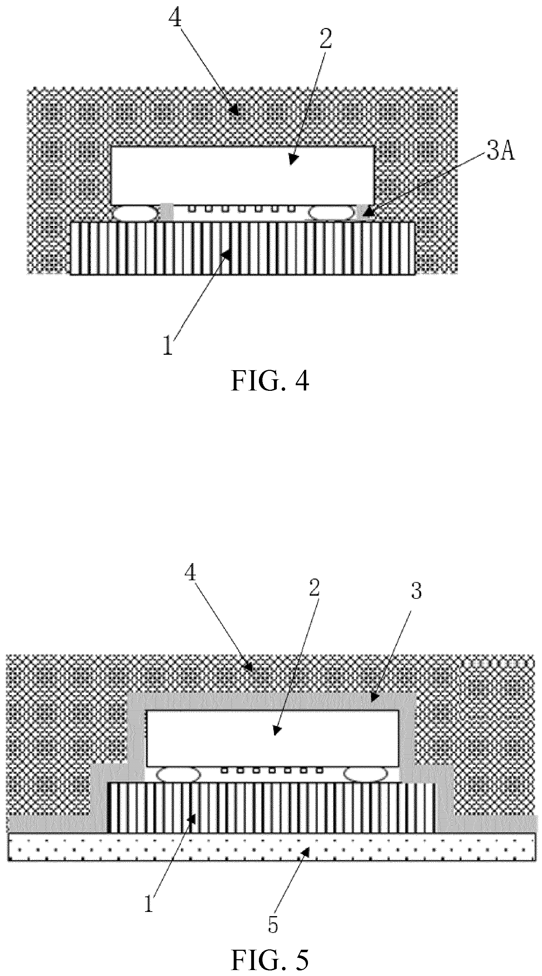

In addition, it can be understood that the retaining walls 3A function to prevent the encapsulant from entering the accommodating cavity 201, thereby protecting the interdigital transducer 23. Therefore, the positions where the retaining walls 3A are arranged only need to ensure that the interdigital transducer 23 can be protected. As shown in FIG. 2, in an embodiment, the retaining walls 3A are arranged on outer sides of the conductive pads 22. As shown in FIG. 3, in another embodiment, the retaining walls 3A are arranged on inner sides of the conductive pads 22 and located on an outer side of the interdigital transducer 23. As shown in FIG. 4, in still another embodiment, the retaining wall 3A on the left side is arranged on the outer side of the conductive pad 22, and the retaining wall 3A on the right side is arranged on the inner side of the conductive pad 22 and located on the outer side of the interdigital transducer 23.

Except for the above structure, the other structures in this embodiment are the same as in the first embodiment and will not be described in detail here.

### Third Embodiment

As shown in FIG. 5, based on the first embodiment, a third embodiment of the present disclosure further provides a filter structure. This embodiment is different from the first embodiment in that the filter structure further includes a carrier 5.

Specifically, the carrier 5 is a rectangular board, and the carrier 5 has a large surface area, so that multiple the IPD dies 1 can be arranged on a surface of the carrier 5 and a preset spacing is provided between every two adjacent IPD dies so as to form dicing lanes 20. Thereby, multiple filter structures can be packaged at one time, and the dicing lanes 20 are cut by a dicing blade to form individual filter structures, thereby improving the production efficiency of the filter structures.

Except for the above structure, the other structures in this embodiment are the same as in the first embodiment and will not be described in detail here.

### Fourth Embodiment

As shown in FIG. 6, based on the first embodiment, a fourth embodiment of the present disclosure further provides a packaging module of a filter structure, including a module substrate 10 and any of the filter structures in the first embodiment to the third embodiment.

A surface of the module substrate 10 has a preset circuit. During installation, an IPD die 1 of the filter structure is attached to the surface of the module substrate 10 and electrically connected to the preset circuit. In this way, a matching circuit of the module substrate 10 can be omitted, so that the package area of the filter structure on the module substrate 10 can be reduced, which facilitates the arrangement of other semiconductor devices that need to be packaged on the module substrate 10.

### Fifth Embodiment

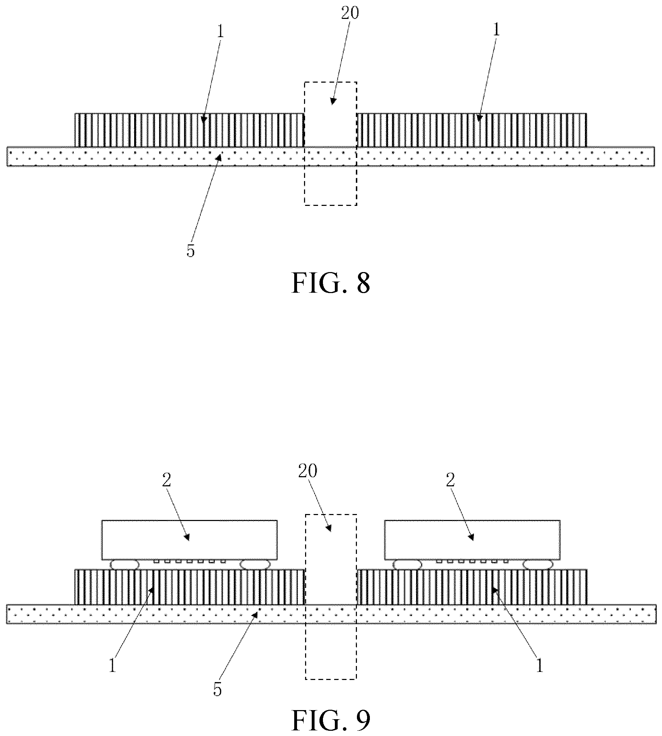

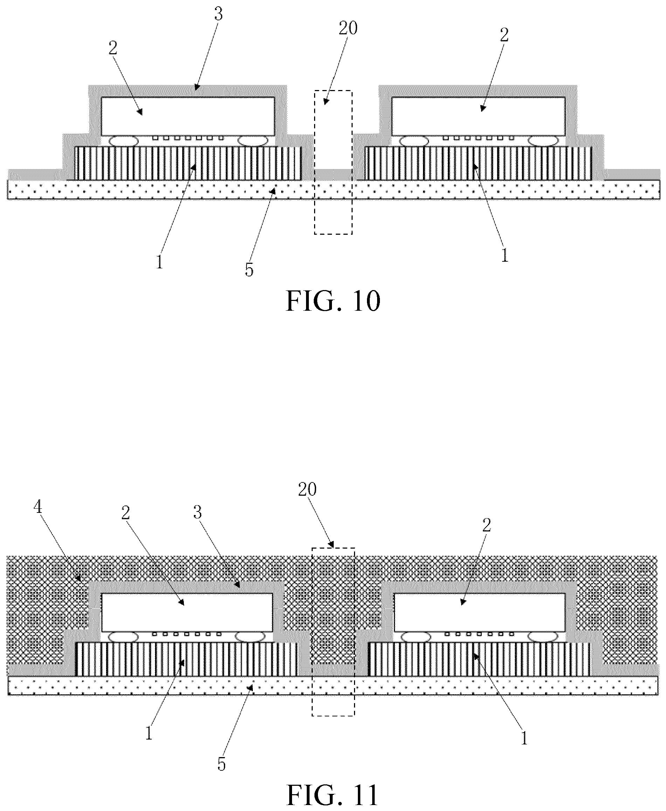

As shown in FIG. 7 to FIG. 11, a sixth embodiment of the present disclosure provides a manufacturing method of a filter structure integrated with an IPD chip, which is used for preparing the filter structure provided by the first embodiment. The manufacturing method specifically includes step S1 to step S6:
S1: Arrange an adhesive on a surface of a carrier 5.
   As shown in FIG. 7, a rectangular carrier 5 is prepared in advance, and a double-faced adhesive tape is attached to the surface of the rectangular carrier 5. It can be understood that in other embodiments, the adhesive is not limited to the double-faced adhesive tape, and may also be a liquid or a semisolid that is arranged by smearing.
S2: Attach IPD dies 1.
   As shown in FIG. 8, multiple IPD dies 1 are attached to preset positions on the surface of the carrier 5 respectively, such that a preset spacing is provided between every two adjacent IPD dies 1 so as to form dicing lanes 20.
S3: Attach filter dies 2.
   As shown in FIG. 9, after the IPD dies 1 are attached, multiple filter dies 2 are attached to surfaces of the multiple IPD dies 1 respectively such that conductive pads 22 of the multiple filter dies 2 are electrically connected to the multiple IPD dies 1 respectively.
S4: Cover with a polymer thin film.
   As shown in FIG. 10, after the filter dies 2 are attached to each of the IPD dies 1, a polymer thin film is used to cover the IPD dies 1 and the filter dies 2 so as to form a thin film layer 3.
S5: Encapsulate.
   As shown in FIG. 11, after the covering with the thin film layer 3 is completed, an encapsulant (an epoxy encapsulant in this embodiment) is used to encapsulate the surface of the carrier 5 and completely cover the thin film layer 3 so as to form an encapsulation layer 4.
S6: Dice.

After the encapsulation is completed, a dicing blade is used to dice the dicing lanes 20, and the carrier 5 is removed to form the individual filter structure integrated with an IPD chips (as shown in FIG. 1).

It can be understood that in the above method, the multiple filter structures can be manufactured by placing the multiple IPD dies 1 on the carrier 5 at one time. In another embodiment, one IPD die 1 may be placed on the carrier 5 to produce one filter structure at one time, which may be adaptively selected according to production needs.

In addition, in the above embodiment, step S4 may further be replaced with S4A:
S4A: Arrange retaining walls 3A.

Specifically, after the filter dies 2 are attached to each of the IPD dies 1, retaining walls 3A are arranged between the IPD die 1 and the filter die 2 in each group such that the encapsulant can be prevented from entering the filter dies 2 during encapsulation. The positions where the retaining walls 3A are arranged are the same as in the second embodiment and will not be described in detail here.

Based on the above, the filter structure integrated with an IPD chip and the manufacturing method thereof provided by the embodiments of the present disclosure have the following beneficial effects:
1. The IPD die 1 that needs to be attached to the module substrate 10 is integrated onto a filter, thereby increasing a space utilization rate of the applied module substrate when the filter is attached subsequently. Without increasing the size of the filter, the IPD die 1 is integrated as a filter package substrate to realize a filter package and allow the filter to form a complete circuit, thereby ensuring the use effect of the filter.
2. The encapsulant of the encapsulation layer 4 satisfies the preset conditions, thereby reducing the possibility of the encapsulant entering the accommodating space 201 and ensuring the encapsulation effect.
3. The encapsulation process is simple, and can effectively improve the production efficiency of the filter structures.

The filter structure integrated with an IPD chip, and the packaging module and the manufacturing method thereof provided by the present disclosure have been described in detail above. For a person of ordinary skill in the art, any obvious changes made to the present disclosure without departing from the essential contents of the present disclosure will constitute an infringement of the patent right of the present disclosure, and the corresponding legal responsibility shall be assumed.

## Claims

1. A filter structure integrated with an IPD chip, comprising:
an IPD die, configured to be electrically connected to a module substrate;
a filter die, arranged on a surface of the IPD die and electrically connected to the IPD die;
a thin film layer, covering outer sides of the IPD die and the filter die; and
an encapsulation layer, encapsulating the surface of the IPD die to completely cover the thin film layer.

2. The filter structure according to claim 1, wherein the filter die comprises:
a filter die body, located above the surface of the IPD die;
conductive pads, formed on a bonding surface of the filter die body and electrically connected to the IPD die such that an accommodating cavity is formed between the bonding surface of the filter die body and the surface of the IPD die, wherein the bonding surface of the filter die body is close to the surface of the IPD die; and
an interdigital transducer, formed on the bonding surface of the filter die body and located in the accommodating cavity.

3. The filter structure according to claim 2, wherein
the thin film layer is replaced with retaining walls, and the retaining walls are arranged between the IPD die and the filter die body to prevent an encapsulant from entering the accommodating cavity.

4. The filter structure according to claim 3, wherein
the retaining walls are arranged on outer sides of the conductive pads; or
the retaining walls are arranged on inner sides of the conductive pads and located on an outer side of the interdigital transducer.

5. The filter structure according to claim 1, wherein
an encapsulant of the encapsulation layer at least satisfies the following: a particle diameter of the encapsulant is greater than a preset diameter; and/or a flow velocity of the encapsulant is less than a preset flow velocity; and/or a viscosity of the encapsulant is greater than a preset viscosity.

6. The filter structure according to claim 1, further comprising a carrier, wherein a surface of the carrier is provided with a plurality of the IPD dies, and a preset spacing is provided between every two adjacent IPD dies such that a dicing blade performs dicing.

7. A packaging module of a filter structure, comprising:
a module substrate, provided with a preset circuit therein; and
the filter structure according to any of claims 1 to 6, an IPD die of the filter structure being attached to a surface of the module substrate and electrically connected to the preset circuit.

8. A manufacturing method of a filter structure integrated with an IPD chip, comprising the following steps:
arranging an adhesive on a surface of a carrier;
attaching a plurality of IPD dies to preset positions on the surface of the carrier respectively;
attaching a plurality of filter dies to surfaces of the plurality of IPD dies respectively such that conductive pads of the plurality of filter dies are electrically connected to the plurality of IPD dies respectively;
using a polymer thin film to cover the IPD dies and the filter dies so as to form a thin film layer;
using an encapsulant to encapsulate the surface of the carrier and completely cover the thin film layer so as to form an encapsulation layer; and
performing dicing after the encapsulation is completed, and removing the carrier to form the individual filter structure integrated with an IPD chips.

9. The manufacturing method according to claim 8, wherein the using a polymer thin film to cover the IPD dies and the filter dies so as to form the thin film layer is replaced with:
arranging retaining walls between the IPD die and the filter die in each group such that the retaining walls are located on outer sides of the conductive pads of the filter die.

10. The manufacturing method according to claim 8, wherein the using a polymer thin film to cover the IPD dies and the filter dies so as to form the thin film layer is replaced with:
arranging retaining walls between the IPD die and the filter die in each group such that the retaining walls are located on inner sides of the conductive pads of the filter die and on an outer side of an interdigital transducer of the filter die.
